Europäisches Patentamt

European Patent Office

Office européen des brevets

(19)

(11) **EP 0 954 103 A1**

(12) **EUROPEAN PATENT APPLICATION**

(43) Date of publication:
**03.11.1999 Bulletin 1999/44**

(51) Int. Cl.$^6$: **H03L 7/107**, H04B 1/707

(21) Application number: **98303113.9**

(22) Date of filing: **22.04.1998**

(84) Designated Contracting States:
**AT BE CH CY DE DK ES FI FR GB GR IE IT LI LU
MC NL PT SE**
Designated Extension States:
**AL LT LV MK RO SI**

(71) Applicant:
**LUCENT TECHNOLOGIES INC.
Murray Hill, New Jersey 07974-0636 (US)**

(72) Inventor:
**Creighton, Richard Samuel
Bath BA1 6DY (GB)**

(74) Representative:
**Watts, Christopher Malcolm Kelway, Dr. et al
Lucent Technologies (UK) Ltd,
5 Mornington Road
Woodford Green Essex, IG8 0TU (GB)**

(54) **Delay locked loop and method of operation**

(57)    A delay locked loop, for example in a receiver of a code division multiple access (CDMA) system has a digital loop filter (7) and a controller (8) which dynamically adjusts one or more parameters of the loop filter so that the natural frequency $\omega_n$ of the loop starts at a larger initial value, favouring acquisition of lock, and is progressively reduced towards a smaller value, favouring stability. It is thus possible to design the loop with good stability without compromising on its ability to acquire lock.

FIG. 2

Printed by Xerox (UK) Business Services
2.16.7/3.6

## Description

### Field of the Invention

This invention relates to delay locked loop such as are used in code division multiple access (CDMA) systems.

### Background of the Invention

Code division multiple access is a well known method of allowing multiple users access to a common communication channel, such as a radio band or optical fibre. Much literature has been published on the subject, for example "Introduction to Spread Spectrum Communications", by Roger L. Peterson, Rodger E. Wiemer and David E. Borth, published by Prentice Hall.

The basis of the technique is the multiplication of the user data channels by higher rate sequences so that when the products are summed to form a single signal, the original user data may be recovered by correlation of the signal against the original sequences. The multiplication and summation process is generally referred to as "CDMA modulation" and the high rate sequences as "spreading codes". A single element of a spreading code is known as a "chip", and the timing reference used to synchronise the code generators a the "chipping clock".

Further levels of modulation may be applied to the CDMA modulated signal to enable transmission ever, for example, a radio channel to a receiver. Following demodulation to recover the CDMS modulated signal, the receiver must correlate the signal against one of the original spreading codes to regenerate an individual user data stream. It is clear therefore that one or more spreading codes must be generated locally and, in addition, the local code must be aligned to the codes embedded in the received signal. The maintenance of the alignment of the local spread code or codes with the received codes, that is to say the minimising of the delay between them, is the function of a delay locked loop (DLL).

In many cases, one spreading code is allocated in the modulator as a reference for the DLL. This code is not modulated with user data and can be regarded as a pilot code. All other codes will be aligned to the pilot and hence if the DLL locks to the pilot, the timing information is available for the generation of the other spreading codes.

Initially, locally generated codes will be out of alignment with the codes embedded in the received signal. Then the task of the DLL is to pull them into alignment. Its task is then to maintain alignment between the codes. It is desirable that a DLL should be capable of achieving aligment quickly and reliably. On the other hand it is also desirable that it should be able to maintain aligment in a stable way, even in the presence of noise and interference. To a great extent these two desired features are mutually inconsistent, since to be able to achieve aligment quickly the DLL must react quickly to any detected misalignment, and to be stable in the presence of noise and interference it must not react too quickly to what may in the short term be indistinguishable from misalignment. Therefore, in the design of delay locked loops there has to be a compromise between quick acquisition of aligment and stability.

The present invention aims to improve the compromise between quick acquisition and stability, so that both may be improved, or one may be improved without adversely affecting the other.

### Summary of the Invention

The invention is defined in the attached claims. I have found that parameters of a DLL can be changed while the DLL is in operation without adversely affecting its performance. Thus, the parameters can initially be set so as to favour quick acquisition of aligment and then gradually changed to favour stability.

### Brief Description of the Drawings

An embodiment of the invention will now be described with reference to the accompanying drawings, of which:—

FIG. 1 is a block diagram of a known delay locked loop,
FIG. 2 is a block diagram of a delay locked loop according to the invention, and
FIGs 3 to 5 are graphs showing the performance of a delay locked loop according to the invention.

### Detailed Description

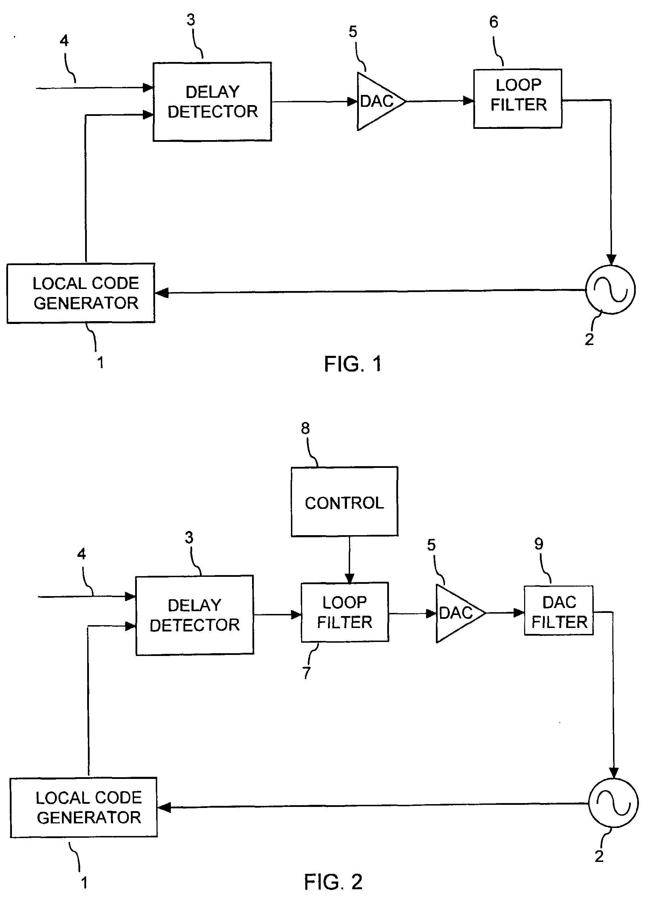

FIG. 1 shows a delay locked loop comprising a local code generator 1, connected to receive a clock signal from a controlled oscillator 2. The local code generator 1 applies the locally generated code to a delay detector, which also receives a CDMA modulated signal in digital form at an input connection 4. This CDMA modulated signal may have been recovered by demodulating a received radio signal. It is the input signal as far as the delay locked loop is concerned. A typical specification for the controlled oscillator 2 is a nominal frequency of the order of 30 MHz with a control range of 200 parts per million. A voltage controlled crystal oscillator would normally be chosen.

The delay detector correlates signals derived from the local code with the CDMA modulated input signal in a well-known way to provide a digital output signal indicative of the delay between the locally generated code and the corresponding code embedded in the received signal. This digital signal is applied to a digital-to-analogue converter 5 which converts the digital output signal of the delay detector 3 to an analogue signal which connected as a control input to the voltage controlled oscillator 2 via a loop filter 6, which is typically a second order active analogue filter.

Ideally the response of the delay detector 3 would be linear, but in practice the estimate of the delay as provided by the delay detector is subject to noise, multiple access interference from the other users and a non-linear response from the detector itself. The output of the delay detector is normally only valid over a small range of delays around zero, often ±0.5 chips from zero delay.

A closed control loop is formed by driving the controlled oscillator 2 with the filtered output of the delay detector 3. The loop filter 6 is critical to the performance of the DLL and provides the means to control the characteristics of the loop. Because the delay detector output is only valid over a small range of delays, the concept of the loop being in or out of lock arises. Where the closed loop keeps the delay within the valid range of the detector, the loop is said to be "in lock". To acquire lock, the local code is aligned to the received code so that the delay is within the valid range of the delay detector and the loop is released. Under these circumstances, acquisition of lock is not guaranteed: there is a finite probability that the loop will fail to pull in and hold the delay within the valid range. This probability depends on the loop characteristics, other initial conditions such as the oscillator frequency, and the noise and interference in the received signal.

## A Linear Model of the Delay Locked Loop

To begin the analysis of the loop, a linear model will be derived in the same form as that often used for second order phase locked loops. For example, see 'Phaselock Techniques', by Floyd M. Gardner, PhD, Wiley Interscience, ISBN 0-47104294-3.

Analysis of the DLL is greatly simplified by assuming that the delay detector 3 is linear and the model resulting from this approximation is very useful in the understanding of the behaviour of the loop.

The delay detector 3 measures the offset between the received pilot signal and the locally generated pilot sequence. The linear model of the delay detector is of the form:—

$$v_d = k_d(\tau_c - \tau_s) \qquad (1)$$

where

$v_d$      output of delay detector 3 (volts)
$k_d$      delay detector gain (volts/sec)
$\tau_c$      received pilot sequence delay from nominal (sec)
$\tau_s$      local pilot sequence delay from nominal (sec)

For convenience, the reference for the loop is taken as the centre frequency of the controlled oscillator

($f_0$). Hence the pilot sequence delays are relative to the sequence that would be generated using a chipping of frequency $f_0$.

The pilot sequence delay is a function of the signal aplied to the controlled oscillator as follows:—

$$\tau_s = \frac{k_0}{f_0} \int v_c dt \qquad (2)$$

where

$v_c$      controlled oscillator control voltage (volts)
$k_0$      controlled oscillator gain (Hz/volt)
$f_0$      controlled oscillator centre frequency (Hz)

Assuming an impulse response $f(t)$ for the loop filter, the above equations may be combined to give:—

$$\tau_s = \frac{k_0 k_d}{f_0} \int ([\tau_s - \tau_c]*f(t)) dt \qquad (3)$$

where the operator "∗" denotes convolution.

Rearranging this equation to give the closed loop transfer function and applying a Laplace transform gives:—

$$H(s) = \frac{\tau_s(s)}{\tau_c(s)} = \frac{k_A F(s)}{s + k_A F(s)} \qquad (4)$$

where

$$k_A = \frac{k_0 k_d}{f_0}.$$

Choosing a filter with integral and proportional terms with a transfer function of the form:

$$F(s) = \frac{1}{sT_1} + \frac{T_2}{T_1} \qquad (5)$$

gives a second order closed loop transfer function:

$$H(s) = \frac{\dfrac{k_A T_2}{T_1} s + \dfrac{k_A}{T_1}}{s^2 + \dfrac{k_A T_2}{T_1} s + \dfrac{k_A}{T_1}} \qquad (6)$$

This equation may be written in the form:—

$$H(s) = \frac{2\zeta\omega_n s + \omega_n^2}{s^2 + 2\zeta\omega_n s + \omega_n^2} \qquad (7)$$

where $\omega_n = \sqrt{\left(\dfrac{k_A}{T_1}\right)}$ and $\zeta = \dfrac{T_2 \omega_n}{2}$.

Here, $\omega_n$ is referred to as the "natural frequency" of the loop and $\zeta$ is referred to as the "damping factor".

The choice of values for these parameters is especially important in the presence of noise and multiple access interference. For example, a low natural frequency will help reject noise and interference. On the other hand, too low a natural frequency will reduce the range of initial conditions over which the loop will reliably acquire lock. With a typical analogue loop filter, the natural frequency will be fixed and a compromise must be made between rejection of noise and interference and the reliability of the lick acquisition process. More sophisticated filters may switch between two values, but the transients introduced by switching analogue components in or out of the analogue filter present loop stability problems.

In the delay locked loop illustrated in FIG. 2 the natural frequency of the loop is controlled dynamically so that a suitable large value is used initially to provide a high probability of acquisition of lock and the value is then progressively reduced, at a rate that does not threaten the stability of the loop, until the desired steady-state value is reached. The steady-state natural frequency can therefore be assigned separately from the initial value, and therefore does not affect the probability of acquisition of lock.

In the circuit shown in FIG. 2 the loop filter 6 of FIG. 1 has been replaced by a digital loop filter 7, controlled by a microprocessor controller 8, upstream of the digital-to-analogue converter 5, and a smoothing (or "reconstruction") filter 9 for the digital-to-analogue converter.

Control of the digital loop filter could be achieved by a hardware implementation or by software, but a software implementation is preferred where a microprocessor is available, because of the flexibility that it provides. A hardware implementation would be constructed from multipliers, adders and storage elements. Since the filter operates on data after correlation, at the (lower) data rate as opposed to the (higher) chip rate, arithmetic blocks can be re-used during a single filter output calculation.

As shown in Equation (7), the natural frequency $\omega_n$ and the damping factor $\zeta$ are given simply as functions of the loop filter parameters $T_1$ and $T_2$. It is therefore a simple matter to determine suitable filter parameters from given requited values of $\omega_n$ and $\zeta$.

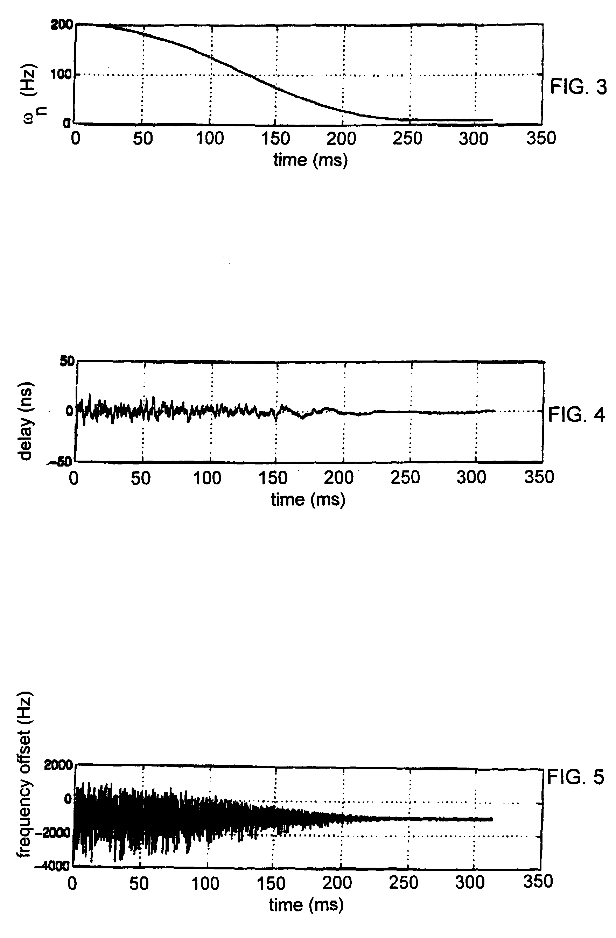

The most straightforward dynamic control involves taking $\omega_n$ through a predetermined trajectory as is shown in FIG. 3. In this simulation, $\omega_n$ is taken from an initial value of 200Hz to a final value of 10Hz via a raised cosine function. The transition is made over 4000 samples of the delay detector output to ensure that the rate of change is small with respect to the natural frequency. FIG. 4 shows a plot of the controlled oscillator frequency against time. The target value is 1KHz below the centre frequency of the controlled oscillator. FIG. 5 shows the delay between the received pilot and the local pilot.

The filter parameters can either be calculated as required or calculated in advance and stored in a look-up table. Simpler trajectories for $\omega_n$ may also be employed if a less complex implementation is necessary. For example, a piece-wise linear or even a simple linear trajectory may be used.

**Claims**

1.   A method of operating a delay locked loop CHARACTERISED BY

initially operating the loop with an initial value of the natural loop frequency favouring acquisition of lock and progressively reducing the natural loop frequency towards a second value favouring stability.

2.   A method as claimed in claim 1 wherein the progressive reduction follows a raised cosine function of time.

3.   A method as claimed in claim 1 wherein the progressive reduction follows a piecewise linear function of time.

4.   A method as claimed in claim 1 wherein the progressive reduction follows a simple linear function of time.

5.   A method as claimed in any of the preceding claims wherein the method is carried out on a delay locked loop within a receiver of a code division multiple access system.

6.   A delay locked loop comprising:

a local code generator (1) for providing a locally generated code signal;
a delay detector (3) having one input connected to receive the locally generated code signal and a second input connected to receive an input signal, the delay detector being adapted to produce a delay signal indicative of an estimate of the delay between the locally generated code signal and a code signal embedded in the input signal;
a controlled oscillator (2) connected to supply a clock signal to the local code generator; and
a loop filter (7) connected between the delay detector and the controlled oscillator to apply a filtered form of the delay signal as a control signal to the controlled oscillator;

CHARACTERISED BY

control means (8) connected control the loop filter so that the natural frequency of the loop is initially at a first value and is progressively reduced towards a second value, lower than the first value.

7. A delay locked loop as claimed in claim 6, wherein the loop filter is a digital filter and the control means is a digital control means.

8. A delay locked loop as claimed in claim 7 further including a digital-to-analogue converter (5) connected between the output of the loop filter and the control input of the controlled oscillator.

9. A delay locked loop as claimed in claim 8 further including an analogue smoothing filter (9) connected between the digital-to-analogue converter and the control input of the controlled oscillator.

10. A code division multiple access receiver including a delay locked loop as claimed in any of claims 6 to 9.

FIG. 1

FIG. 2

FIG. 3

FIG. 4

FIG. 5

| | | EUROPEAN SEARCH REPORT | | Application Number |
|---|---|---|---|---|
| | | | | EP 98 30 3113 |

**European Patent Office**

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | DE 30 25 326 A (SIEMENS AG) 21 January 1982 * page 3, line 8 - page 13, line 35 * * page 6, line 10 - line 15 * * claims 3,4; figures * | 1,5,6,10 | H03L7/107 H04B1/707 |
| Y | | 2-4,7-9 | |
| Y | US 3 909 735 A (ANDERSON ALFRED T ET AL) 30 September 1975 * column 1, line 5 - line 13 * * column 1, line 61 - column 2, line 48 * * column 4, line 22 - column 5, last line; figures 2,3 * | 2-4 | |
| Y | BISHOP A J ET AL: "ADAPTIVE PHASE LOCKED LOOP FOR VIDEO SIGNAL SAMPLING" PROCEEDINGS OF THE INTERNATIONAL SYMPOSIUM ON CIRCUITS AND SYSTEMS, SAN DIEGO, MAY 10 - 13, 1992, vol. 4, no. CONF. 25, 10 May 1992, pages 1664-1667, XP000338265 INSTITUTE OF ELECTRICAL AND ELECTRONICS ENGINEERS * the whole document * | 2-4 | |
| Y | EP 0 341 834 A (DIGITAL EQUIPMENT CORP) 15 November 1989 * page 2, line 43 - line 46 * * page 3, line 10 - line 32 * * page 3, line 53 - page 6, line 33; figures 1,2,4B,4C * | 2-4 | |
| Y | US 5 477 195 A (SPILKER JAMES J) 19 December 1995 * column 2, line 39 - line 62 * * column 6, line 45 - line 57 * * column 7, line 41 - column 9, line 55; figure 8 * | 7-9 | |

TECHNICAL FIELDS SEARCHED (Int.Cl.6)

H03L
H04B

The present search report has been drawn up for all claims

| Place of search | Date of completion of the search | Examiner |
|---|---|---|
| THE HAGUE | 28 September 1998 | Balbinot, H |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)